(19) Europäisches Patentamt
European Patent Office
Office européen des brevets

(11) **EP 1 308 991 A1**

(12) **EUROPEAN PATENT APPLICATION**
published in accordance with Art. 158(3) EPC

(43) Date of publication:
**07.05.2003 Bulletin 2003/19**

(51) Int Cl.⁷: **H01L 21/027**, G03F 7/20,
G01J 1/00, G01B 11/00

(21) Application number: **01984366.3**

(22) Date of filing: **26.06.2001**

(86) International application number:
**PCT/JP01/06429**

(87) International publication number:
**WO 02/009163 (31.01.2002 Gazette 2002/05)**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **26.07.2000 JP 2000225858**

(71) Applicant: **NIKON CORPORATION**
**Tokyo (JP)**

(72) Inventor: **HIKIMA, Ikuo, Nikon Corporation**
**Tokyo 100-8331 (JP)**

(74) Representative: **Gill, David Alan et al**
**W.P. Thompson & Co.,**
**55 Drury Lane**
**London WC2B 5SQ (GB)**

(54) **FLARE MEASURING METHOD AND FLARE MEASURING DEVICE, EXPOSURE METHOD AND EXPOSURE SYSTEM, METHOD OF ADJUSTING EXPOSURE SYSTEM**

(57)     A flare measuring method and a flare measuring apparatus for measuring flaring occurring on optical systems, an exposure method and an exposure apparatus, and an exposure apparatus adjusting method capable of quantitatively measuring information regarding flare which occur on optical systems are to be provided. A flare measuring apparatus S for measuring flare which occur on optical system IL is provided with a light source device for irradiating an optical path including the optical system IL with an exposure light EL, a substrate M1 arranged on the optical path and provided with predetermined patterns C and T, a detecting device DT arranged on the image plane of a projecting optical system PL and capable of detecting information on the luminous energy of the light, and a control device CONT capable of controlling the irradiating range of the exposure light EL and acquiring information on flare on the basis of the result of detection of the exposure light EL by the detecting device DT.

FIG. 3

**Description**

Technical Field

The present invention relates to a flare measuring method and a flare measuring apparatus for measuring flaring occurring in optical system, an exposure method and an exposure apparatus, and an exposure apparatus adjusting method.

The present application is based on Japanese Patent Application (No. 2000-225858), the content of which is incorporated herein by reference.

Background Art

Various exposure apparatuses are already used in manufacturing semiconductor elements, thin film magnetic heads, liquid crystal elements, and the like by photolithographic processes. Such an exposure apparatus illuminates a patterned mask with an illuminating light for exposure (exposure light) via an illuminating optical system, and exposes via a projected optical system a substrate coated with a photosensitive agent or resist (hereinafter to be sometimes referred to as photosensitive substrate) to light having been transmitted by the mask. This causes the image of the pattern on the mask to be transferred to the substrate (resist).

Whereas the optical systems (including the illuminating optical system and the projecting optical system) in the aforementioned exposure apparatus consist of a plurality each of optical members (including lenses), when the exposure light passes any of these optical systems, the exposure light may be sometimes scattered between the optical members and give rise to flare. Once such a flare arises, for instance the luminous energy in the projection area of the projecting optical system where the pattern image of the mask is formed, may become uneven, with the consequence that the contrast of the pattern image on the image plane of the projecting optical system is reduced and no accurate pattern can be formed on the photosensitive substrate. Therefore, in processing exposure to light, it is necessary to measure in advance the positions and luminous energy levels of flare occurring on optical system in advance so that predetermined processing to eliminate flaring can be accomplished. However, according to the prior art, there is available no effective means of measuring the positions and luminous energy levels of flare occurring on optical system.

An object of the present invention, attempted in view of this circumstance, is to provide a flare measuring method and a flare measuring apparatus for measuring flaring occurring on optical system, an exposure method and an exposure apparatus, and an exposure apparatus adjusting method.

Disclosure of the Invention

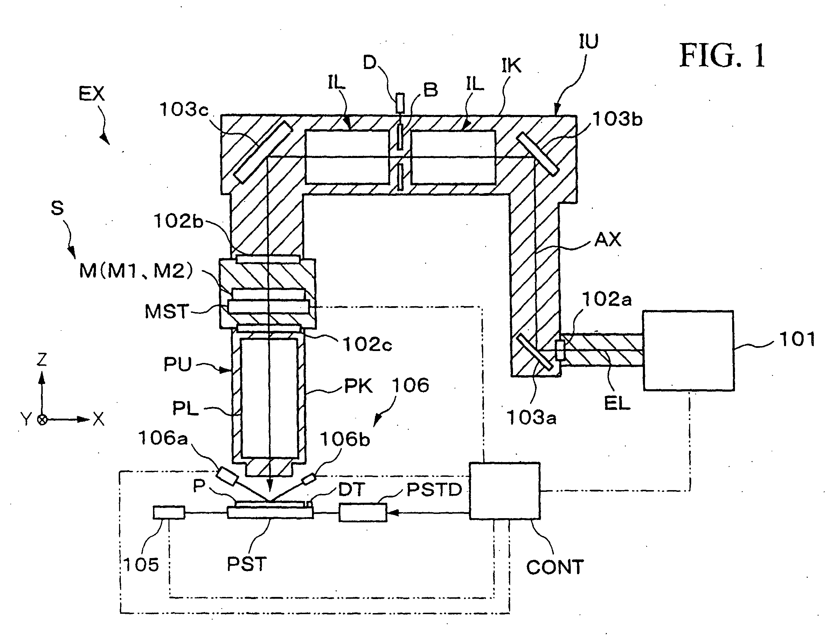

In order to solve the problems noted above, the invention uses the following configurations disclosed in the Modes for Carrying Out the Invention, respectively matching Figure 1 through Figure 8.

A flare measuring method according to one aspect of the invention for measuring flare occurring on optical system (IL and PL) is characterized in that an optical path including substrates (M1 and M2) having predetermined patterns (C and T) and the optical system (IL and PL) is irradiated with first light (EL) and information on this light (EL) is detected in a predetermined position on the optical path, followed by irradiation of the optical path with second light (EL) differing from the first light (EL) in at least one of luminous energy and irradiating range and detection of information on this light (EL) in a predetermined position on the optical path, and information on the flare is acquired on the basis of the respective detection results regarding the first and second light (EL).

According to the invention, by irradiating the optical path including the substrates (M 1 and M2) having the predetermined patterns (C and T) and the optical system (IL and PL) with two lights (EL) differing in at least one of luminous energy and irradiating range and detecting information on each of these lights (EL) in predetermined positions on the optical path, information on flaring occurring on the optical system (IL and PL) can be quantitatively acquired on the basis of the respective detection results. Therefore, on the basis of the information on the flaring quantitatively acquired, predetermined processing for eliminating the flaring can be efficiently accomplished.

A flare measuring apparatus (S) according to one aspect of the invention for measuring flare occurring on optical system (IL and PL) is characterized in that it is provided with a light source device (101) irradiating an optical path including the optical system (IL and PL) with a predetermined light (EL), substrates (M1 and M2) arranged on the optical path and having predetermined patterns (C and T), detecting devices (DT, P and ST) arranged in predetermined positions on the optical path and capable of detecting information regarding the luminous energy of the light, and a control device (CONT) capable of controlling at least one of the luminous energy and the irradiating range of the light (EL) emitted from the light source device (101) and acquiring information on the flare on the basis of the results of detection by the detecting devices (DT, P and ST) of the light (EL) irradiating the optical path.

According to the invention, by irradiating substrates (M1 and M2) having predetermined patterns (C and T) with the lights (EL) differing in at least one of luminous energy and irradiating range from the light source device (101) and detecting each of these lights (EL) with the detecting device (DT, P and ST) provided in the predetermined positions on the optical path, the flaring occurring on the optical system (IL and PL) can be quantitatively acquired on the basis of the respective detection results. Therefore, on the basis of the information on the flaring quantitatively acquired, predetermined processing for eliminating the flaring can be efficiently accomplished.

An exposure method according to one aspect of the invention whereby a mask (M) having a pattern is irradiated with an exposure light (EL) from an illuminating optical system (IL) and an image of the pattern is transferred onto a photosensitive substrate (P) via a projecting optical system (PL) is characterized in that flare occurring on the optical system (IL and PL) is measured by a flare measuring method according to any one of claims 1 through 6 and, after predetermined processing is performed on the basis of the measurement results, the transfer processing is carried out.

According to the invention, as flare occurring on the optical system (IL and PL) are measured and, after predetermined processing to eliminate flaring is performed on the basis of the measurement results, transfer processing is carried out, it is possible to perform accurate transfer processing (exposure processing).

An exposure apparatus (EX) according to another aspect of the invention having an illuminating optical system (IL) a projecting optical system (PL) is characterized in that it is provided with a flare measuring apparatus (S) according to any one of claims 7 through 10.

According to the invention, by providing the flare measuring apparatus (S) capable of measuring flaring occurring on the optical system (IL and PL), it is made possible to measure flare, and then carry out predetermined processing to eliminate the flare. Therefore, it can perform accurate transfer processing (exposure processing) after eliminating flare.

An exposure apparatus adjusting method according to one aspect of the invention for an exposure apparatus (EX) which has an illuminating optical system (IL) for irradiating masks (M) with an illuminating light (EL) from a light source (101) and by which the patterns of the masks (M) are transferred onto substrates (P) is characterized in that substantially only a transmissive pattern (T) is irradiated with the illuminating light (EL) in the area of irradiation by the illuminating optical system (IL) with the illuminating light (EL) to detect that transmitted light (EL), at the same time substantially the whole irradiated area is irradiated with the illuminating light (EL) to detect the light (EL) transmitted by the transmissive pattern (T), and on the basis of this detection result the distribution of illuminance by the illuminating light (EL) on the masks (M) is determined.

According to the invention, as the distribution of illuminance on the masks (M) can be determined in a state in which the influence of the flare that have occurred is taken into consideration, adjustment of an exposure apparatus (EX) to make uniform the distribution of illuminance can be easily and efficiently accomplished.

An exposure apparatus adjusting method according to another aspect of the invention for the exposure apparatus (EX) which has the illuminating optical system (IL) for irradiating a mask (M) with illuminating light (EL) from a light source (101) and a projecting optical system (PL) for projecting the illuminating light on the substrates (P) is characterized in that a light intercepting pattern (C) is arranged in the area of irradiation by the illuminating optical system (IL) with the illuminating light (EL), irradiation with the illuminating light (EL) is performed with its luminous energy varied, information on the luminous energy of the illuminating light (EL) in the position of the light intercepting pattern (C) projected by the projecting optical system (PL) is detected, and the illuminance distribution of the illuminating light (EL) on the image plane of the projecting optical system (PL) is determined on the basis of the result of this detection.

According to the invention, since the illuminance distribution on the image plane of the projecting optical system (PL) can be determined in a state in which the influence of the flare that have arisen is taken into consideration can be determined, adjustment of the exposure apparatus (EX) to make uniform the distribution of illuminance can be easily and efficiently accomplished.

Brief Description of the Drawings

Figure 1 is a diagram for describing an exposure apparatus equipped with a flare measuring apparatus according to one aspect of the present invention;

Figure 2 is a diagram for describing a mask (substrate) for use in a flare measuring method according to a first aspect of the invention;

Figure 3 is a diagram for describing a flare measuring method and measuring apparatus according to the first aspect of the invention;

Figure 4 is a diagram for explaining the quantity of irradiation with an exposure light with which a photosensitive substrate is irradiated by the flare measuring method according to the first aspect of the invention;

Figure 5 is a diagram for describing a mask (substrate) for use in a flare measuring method according to a second aspect of the invention;

Figure 6 is a diagram for describing a flare measuring method and measuring apparatus according to the second aspect of the invention;

Figure 7 is a diagram for describing the quantity of irradiation with an exposure light with which a photosensitive substrate is irradiated by the flare measuring method according to the second aspect of the invention; and

Figure 8 is a flow chart for describing one example of semiconductor device manufacturing process.

Best Modes for Carrying Out the Invention

A flare measuring method, a flare measuring apparatus, an exposure method, and an exposure apparatus according to one aspect of the present invention will be described below with reference to drawings. Figure 1 is a diagram for describing an exposure apparatus EX equipped with a flare measuring apparatus S according to one aspect of the present invention.

As shown in Figure 1, the exposure apparatus EX comprises an illuminating unit IU provided with an illuminating optical system IL for illuminating masks (including a reticle) M (M1 and M2) with a luminous flux from a light source (light source device) 101, a blind unit (irradiating range adjusting device) B arranged within this illuminating optical system IL as a field of view diaphragm to define the range of the masks M illuminated by this exposure light EL by adjusting area, position and shape of the exposure light EL, and a projecting unit PU arranged within a casing (body tube) PK and provided with a projecting optical system PL for projecting the image of the patterns of the masks M illuminated with the exposure light EL onto a photosensitive substrate P.

The light source 101 is configured of ArF excimer laser of 193 nm in oscillation wavelength, fluorine laser ($F_2$ laser) of 157 nm in oscillation wavelength, krypton dimmer laser ($Kr_2$ laser) of 146 nm in oscillation wavelength or argon dimmer laser ($Ar_2$ laser) of 126 nm in oscillation wavelength. Incidentally, as the light source 101, a mercury lamp, a KrF excimer laser or a harmonic generating device such as a YAG laser or a solid laser (semiconductor laser or the like) may as well be used, and in this example, any type of the light source 101 or an exposure light EL of any wavelength may be used.

The exposure light EL emitted from the light source 101 passes a window portion 102a. is reflected by a mirror 103a and a mirror 103b of the illuminating unit IU, and is incident on the illuminating optical system IL. The illuminating optical system IL has a plurality of optical members including a relay lens, an optical integrator for making uniform the distribution of illuminance of the exposure light EL, an input lens for bringing the exposure light EL to incidence on the optical integrator, a condenser lens for condensing the exposure light EL emitted from the optical integrator onto the masks M, an aperture stop and a light attenuating filter. These optical members are arranged in a casing IK.

In this process, the exposure light EL may become scattered between the optical members constituting the illuminating optical system IL including the masks M and give rise to flare.

The blind unit B is bent, for instance in a planar L shape, and is provided with a pair of blades, which constitute a rectangular opening by being combined with each other in a plane orthogonal to the optical axis AX of the illuminating optical system IL, and a drive mechanism D, which displaces these blades in a plane orthogonal to the optical axis AX, and is controlled by a control device CONT. In this process, the size of the opening and other factors of the blind unit B vary with the displacement of the blades, and only the part of the incident exposure light EL that has passed is delivered towards the masks M. The exposure light EL defined by the opening of the blind unit B illuminates a specific area of the masks M held by a mask stage MST at a substantially uniform level of illuminance. Though not shown, the position and the extent of rotation of the mask stage MST are measured by a laser interferometer.

The exposure light EL emitted from the illuminating optical system IL is reflected by a mirror 103c, passes a window portion 102b, and is incident on the masks M on the two-dimensionally shiftable mask stage MST. The exposure light EL having been transmitted by the masks M further is incident on the projecting optical system PL in the projecting unit PU via a window portion 102c, is transmitted by a plurality of lenses (optical members) constituting this projecting optical system PL to be incident on the photosensitive substrate P, and forms the image of the patterns of the masks M on the surface of the photosensitive substrate P.

In this process, the exposure light EL may become scattered between the optical members constituting the projecting optical system PL including the masks M and the photosensitive substrate P and give rise to flare.

The photosensitive substrate P is installed on a substrate stage PST, which can shift in three-dimensional directions (XYZ directions), and the position and the extent of rotation (the extent of yawing and the like) of this substrate stage PST in the XY plane are measured by a laser interferometer 105. On the other hand, the position and the extent of inclination of the substrate stage PST in the Z direction are measured by a focus detecting line 106 provided with a projecting line 106a and a light receiving line 106b. The results of detection by these laser interferometer 105 and focus detecting line 106 are outputted to the control device CONT, and the substrate stage PST is shifted via a drive mechanism PSTD in accordance with instructions from the control device CONT.

On the substrate stage PST is provided an optical detecting device (illuminance sensor) DT capable of detecting information on the luminous energy of the exposure light EL arriving on this substrate stage PST. This detecting device DT can detect the luminous energy (illuminance) on the surface (exposable face) of the photosensitive substrate P, namely the image plane (in a predetermined position) of the projecting optical system PL, and is configured of a pinhole sensor in this example. In this disposition, the optical detecting device DT can be shifted to any desired position by the shifting of the substrate stage PST.

Incidentally, the exposure apparatus EX according to this aspect of the invention is a step-and-repeat type exposure apparatus which performs exposure to the patterns of the masks M in a state in which the masks M and the photosensitive substrate P are kept stationary and the photosensitive substrate P is successively shifted step by step.

Next will be described how flare arising on the optical path of the exposure light EL are measured with the exposure apparatus EX provided with the illuminating optical system IL and the projecting optical system PL described above. The flare measuring method here according to the invention consists of a method of measuring flare arising between the illuminating optical system IL and the masks M and a method of measuring flare arising between the masks M including the projecting optical system PL and the photosensitive substrate P. Thus, flare arising between the illuminating optical system IL and the masks M and flare arising between the masks M including the projecting optical system PL and the photosensitive substrate P are measured independent of each other.

<Method of measuring flare arising between illuminating optical system and masks>

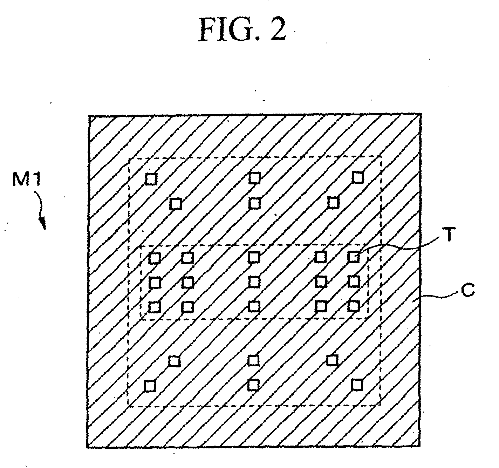

First, as a first embodiment, the method of measuring flare arising between the illuminating optical system IL and the masks M will be described. Here, flare arising between the illuminating optical system IL and the masks M, as shown in Figure 1 and Figure 2, are measured with the flare measuring apparatus S provided with the light source (light source device) 101 for irradiating the optical path including the illuminating optical system IL and the projecting optical system PL with the exposure light (predetermined light, illuminating light) EL, a mask (substrate) M1 arranged on the mask stage MST on this optical path and having a predetermined pattern, the optical detecting device DT capable of detecting information (illuminance) on the luminous energy of the exposure light EL on the image plane (in a predetermined position) of the projecting optical system PL on the substrate stage PST, and the control device CONT capable of controlling at least one of the luminous energy and the irradiating range of the exposure light EL emitted from the light source 101 and to which the result of detection by the optical detecting device DT is supplied.

As shown in Figure 2, the mask (first mask) M1 is provided with a chromium portion (the light intercepting pattern) C which reflects the exposure light EL emitted by the illuminating optical system IL and trimming patterns (transmissive patterns) T transmitting the light. The chromium portion C is provided all over the mask M1, and the trimming patterns T are quadrangles (squares) each of whose side measures about 4 mm for instance, and are provided in a plurality in predetermined positions including the central part and the peripheral part of the mask M1 in the direction of the plate surface. In this disposition, the transmittance of the trimming patterns T for the exposure light EL is set to 10% or below. Thus, the part of the exposure light EL transmitted by the masks M in the area irradiated with the exposure light EL is more than 10% of the exposure light EL incident on the masks M, and the rest is reflected by the masks M.

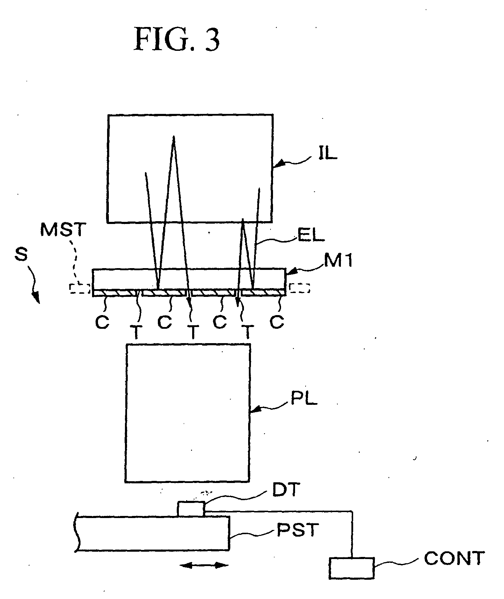

As shown in Figure 3, it is so disposed that the exposure light EL irradiating the chromium portion C of the mask M1 be reflected towards the illuminating optical system IL and intercepted from traveling towards the substrate stage PST. On the other hand, it is further so disposed that the part of the exposure light EL irradiating the trimming patterns T of the mask M1 and transmitted by these trimming patterns T be transmitted by the projecting optical system PL to reach the substrate stage PST and detected by the optical detecting device DT provided on this substrate stage PST. Incidentally, in this embodiment, the photosensitive substrate P is not arranged on the substrate stage PST.

Flare arising between the illuminating optical system IL and the mask M1 are measured with this flare measuring apparatus S by a method comprising a step of detecting in advance, under conditions where no flare arise, information on luminous energy in a predetermined position corresponding to the surface of the photosensitive substrate P on the substrate stage PST (the image plane of the projecting optical system) (step Sa1), a step of detecting luminous energy in a predetermined position by irradiating the mask M1 with the exposure light EL from the illuminating optical system IL under predetermined conditions (normal conditions of exposure to light) (step Sa2), and a step of acquiring information on flare on the basis of information on luminous energy detected at step Sa1 and step Sa2 (step Sa3).

[Step Sa1]

As shown in Figure 3, after installing the mask M1 having the trimming patterns T capable of transmitting the exposure light EL and having a predetermined size on the mask stage MST downstream on the optical path of the illuminating optical system IL, first the mask M is irradiated with the exposure light EL from the illuminating optical system IL under conditions where no flare occur. The conditions under which no flare occur then can be achieved by irradiating only the trimming patterns T in the mask M1 with the exposure light EL.

More specifically, the blind unit (irradiating range adjusting device) B installed on the illuminating optical system IL is so adjusted that the exposure light EL having passed the opening of this blind unit B irradiates only one of the plurality of the trimming patterns T formed in the mask M1. Thus, the opening of the blind unit B is adjusted according to the rectangular shape of the trimming patterns T, and so set that the exposure light EL having passed the opening of this blind unit B irradiates only one of the trimming patterns T but no other trimming pattern T. That is, the exposure light EL is caused to irradiate substantially only the trimming pattern T in the area of irradiation of the mask M1 by the illuminating optical system IL with the exposure light EL. As the exposure light EL whose irradiating range has been adjusted by the blind unit B (with respect at least to the size and position in this embodiment) is transmitted by only one trimming pattern T and not scattered by the chromium portion of the mask M1 C or between the members of the illuminating optical system IL, no flare occur in this state. Further, the substrate stage PST is shifted so that the optical detecting device DT is positioned where the exposure light EL irradiates and the one trimming pattern T is projected.

The exposure light EL whose irradiating range has been adjusted by the blind unit B and which has been transmitted by the one trimming pattern T, after being transmitted by the projecting optical system PL, undergoes illuminance detection by the optical detecting device DT arranged on the substrate stage PST. Thus, the optical detecting device DT detects the illuminance of the exposure light EL in predetermined position (irradiated position) on the image plane of the projecting optical system PL corresponding to the position where the trimming pattern T is formed under conditions where no flare occur. Then, the result of detection of the illuminance of the exposure light EL transmitted by the one trimming pattern T on the image plane is supplied to the control device CONT. Information on the position of the optical detecting device DT is then also supplied from the laser interferometer 105 to the control device CONT.

After irradiating the one trimming pattern T with the exposure light EL and thereby detecting the illuminance of the exposure light EL transmitted by this trimming pattern T, the blind unit B is so adjusted that the exposure light EL irradiate another trimming pattern T and the substrate stage PST is shifted to irradiate this other trimming pattern T with the exposure light EL. The optical detecting device DT, in the same way as described before, detects the illuminance of the exposure light EL transmitted by this other trimming pattern T. Similarly thereafter, each of the plurality of trimming patterns T provided in the mask M1 is successively irradiated with the exposure light EL by adjusting the blind unit B, and the substrate stage PST is stepped to detect with the optical detecting device DT the illuminance on the image plane of the exposure light EL transmitted by each of these trimming patterns T.

[Step Sa2]

When each of the plurality of trimming patterns T has been irradiated with the exposure light EL and the illuminance of each part of the exposure light EL transmitted by these trimming patterns T has been detected on the image plane of the projecting optical system PL, the blind unit B is returned to predetermined conditions.

Thus in this embodiment, so that usual conditions can be achieved under which exposure is performed using the illuminating optical system IL, the opening of the blind unit B is expanded to make the irradiating range different from that at step Sa1 to enable the whole mask M1 (patterned area) to be irradiated with the exposure light EL. In this state, the exposure light EL is radiated from the illuminating optical system IL towards the mask M1. Thus, substantially the whole area of irradiation with the exposure light EL by the illuminating optical system IL is irradiated with the exposure light EL. The output of the light source 101 then (the luminous energy of the exposure light EL emitted from the illuminating optical system IL towards the mask M1) is set to be equal to the output (the luminous energy) at step Sa1. The exposure light EL, whose irradiating range is so adjusted by the blind unit B to irradiate the whole mask M1, passes each of the plurality of trimming patterns T of the mask M1, and is detected by the optical detecting device DT provided on the substrate stage PST. The optical detecting device DT detects illuminance in a position on the image plane of the projecting optical system PL corresponding to the projecting position of each of the trimming patterns T, and supplies the result of this detection to the control device CONT.

[Step Sa3]

The control device CONT acquires information on flare on the basis of the result of detection at step Sa1, i.e., illuminance A1 on the image plane of the projecting optical system PL of the exposure light EL (first light) irradiating only the trimming patterns T of the mask M1, and the result of detection at step Sb2, i.e. illuminance A2 in a predetermined position on the image plane of the projecting optical system PL corresponding to the position where the trimming patterns T are formed of the exposure light EL (second light) irradiating the whole mask M1.

Now, if there is any flare occurring between the illuminating optical system IL and the mask M1, the illuminance A2 detected at step Sa2 is greater than the illuminance A1 detected at step Sa1. On the other hand, if there is no flare occurring, the illuminance A1 detected at step Sa1 and the illuminance A2 detected at step Sa2 are equal. Therefore, the control device CONT compares the illuminance A1 detected at step Sa1 and the illuminance A2 detected at step Sa2 and, if it finds the illuminance A2 to be greater, will judge that a flare has occurred in a position corresponding to this trimming pattern T. Furthermore, by computing the difference between the illuminance A1 and the illuminance A2, it determines the luminous energy (illuminance) of the flare occurring on the illuminating optical system IL at a position corresponding to this trimming pattern T.

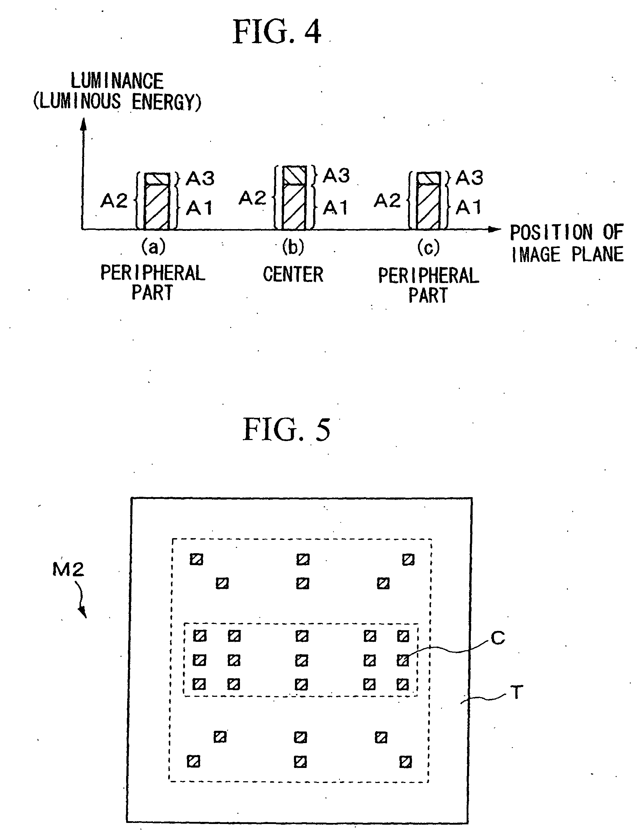

Thus, as shown in Figure 4, where A1 is the illuminance that is detected at step Sa1 in the predetermined position on the image plane of the projecting optical system PL corresponding to the position of the trimming pattern T and A2 is the illuminance similarly detected at step Sa2, the illuminance (luminous energy) A3 of the flare in this position is:

$$A3=A2-A1 \qquad (1)$$

Incidentally, in Figure 4, the horizontal axis represents the image plane position and the vertical axis, the illuminance (the luminous energy).

Then, on the basis of the illuminance quantities A1 and A2 in the positions on the image plane of the projecting optical system PL corresponding to the plurality of trimming pattern T provided in the direction of the plate surface in the mask M1, it is judged whether or not there is any flare in the positions respectively corresponding to these positions and, if there is any flare occurring, the illuminance (luminous energy) of the flare in each position is determined. Thus, as shown in (a) through (c) in Figure 4, it is possible to determine the illuminance (luminous energy) A3 of flare in a plurality of positions including the central and peripheral parts of the mask M1. Thus, in this embodiment, it is possible to quantitatively acquire various information regarding flare including whether or not there is any flare on the illuminating optical system IL, the illuminance (luminous energy) of that flare if there is, and the distribution of illuminance of that flare. In addition, the number of flare measuring points may be increased by shifting the mask stage MST by a predetermined extent at a time to repeatedly execute steps Sa1 and Sa2 described above and thereby to enhance the accuracy of measuring the distribution of illuminance. Furthermore, when the illuminance of the exposure light EL in the projecting position of each trimming pattern T is to be detected in steps Sa1 and Sa2, the intensity (luminous energy) of the exposure light EL emitted from the light source 101 can be varied from pulse to pulse. Then, it is preferable to divide and detect with an optical detector (integrator sensor) part of the exposure light EL emitted from the optical integrator in the illuminating optical system IL and, at the time of the aforementioned detection of the exposure light EL by the optical detecting device DT, to normalize the aforementioned illuminance quantities A1 and A2, or at least correct part of the illuminance quantities A1 and A2, on the basis of a signal (intensity of the exposure light EL) supplied from this integrator sensor. In this procedure, an optical detector arranged in the light source 101 may also be used in place of the integrator sensor.

<Method of measuring flaring arising between masks, projecting optical system and photosensitive substrate>

Next, as a second embodiment, the method of measuring flare arising between the masks M including the projecting optical system PL and the photosensitive substrate P will be described. Here, flare arising between the masks M including the projecting optical system PL and the photosensitive substrate P are measured with the flare measuring apparatus S described with reference to the first embodiment, and the same reference signs will be used for the same constituent parts as, or equivalent ones to, their respective counterparts in the above-described first embodiment, with their description being either simplified or dispensed with.

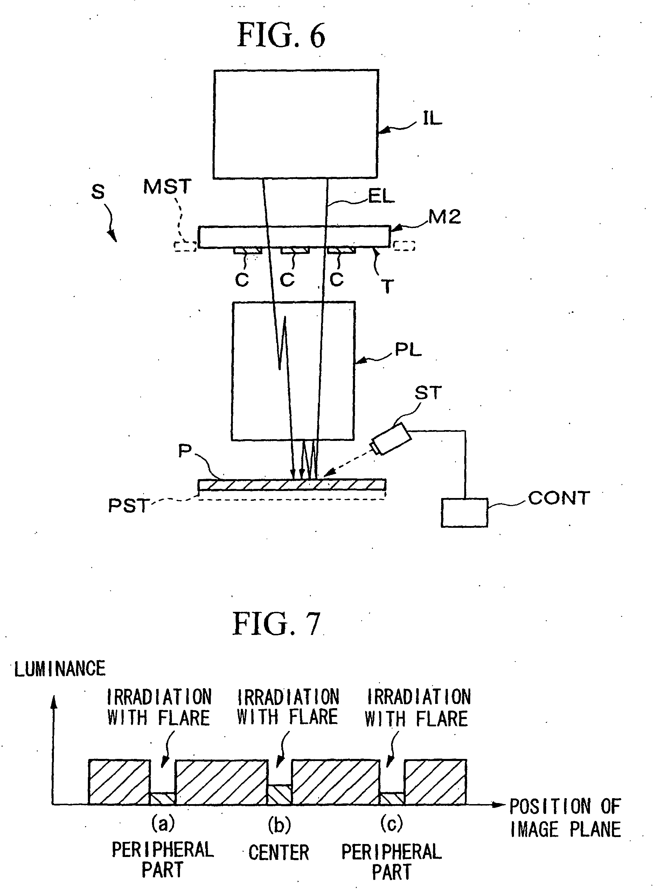

In addition, in this embodiment, the illuminance sensor DT referred to in the first embodiment is not used, but instead the photosensitive substrate P is installed on the substrate stage PST, this photosensitive substrate P is irradiated with the exposure light EL via a mask M (M2), the pattern shape formed on this photosensitive substrate P is measured with the shape measuring apparatus ST shown in Figure 6, and information on flare is acquired on the basis of the result of measurement with this shape measuring apparatus ST and the luminous energy of the irradiating exposure light EL. Thus, in this embodiment, detecting device (detecting means) for detecting information on the exposure light EL is configured of the shape measuring apparatus ST capable of measuring the pattern shape of the mask M (M2) formed on the photosensitive substrate P, and it is disposed so that the result of measurement by the shape measuring apparatus ST is supplied to the control device CONT. The shape measuring apparatus ST is configured of an SEM, an atomic force microscope or the like.

The mask (second mask) M2 used in this embodiment, as shown in Figure 5, is provided with chromium patterns (light intercepting patterns) C which reflect the exposure light EL radiated by the illuminating optical system IL and a transmissive portion (transmissive pattern) T which transmits light. The transmissive portion T is provided all over the mask M2, and the chromium patterns C are quadrangles (squares) each of whose side measures about 4 mm for instance, and provided in a plurality in predetermined positions including the central part and the peripheral part of the mask M2 in the direction of the plate surface. In this disposition, the transmittance of the transmissive portion T for the exposure light EL is set to 90% or above.

As shown in Figure 6, the exposure light EL irradiating the chromium patterns C of the mask M2 is intercepted from irradiating the photosensitive substrate P on the substrate stage PST. On the other hand, the exposure light EL transmitted by the transmissive portion T of the mask M2 is transmitted by the projecting optical system PL to reach the substrate stage PST, and irradiates the photosensitive substrate P provided on this substrate stage PST.

Flare arising between the mask M2 including the projecting optical system PL and the photosensitive substrate P are measured with this flare measuring apparatus S by a method comprising a step of irradiating, under conditions where no flare is detected, the photosensitive substrate P with the exposure light EL from the illuminating optical system IL and thereby detecting in advance information on the luminous energy of the exposure light EL then (step Sb1), a step of irradiating the photosensitive substrate P with the exposure light EL under predetermined conditions (conditions of greater than usual exposure to light) and thereby detecting information on the luminous energy then (step Sb2), and a step of acquiring information on flare on the basis of information on the luminous energy detected at step Sa1 and step Sa2 (step Sb3).

[Step Sb1]

As shown in Figure 6, after installing the mask M2 provided with the chromium patterns C each having a predetermined size large enough for intercepting the exposure light EL on the mask stage MST upstream on the optical path of the projecting optical system PL, the mask M2 is irradiated with the exposure light EL from the illuminating optical system IL under conditions where no flare is detected.

First, the light source 101 is controlled with the control device CONT to set the luminous energy low to irradiate the mask M2 all over with the exposure light EL from the illuminating optical system IL. This exposure light EL, after being transmitted by the transmissive portion T of the mask M2 and the projecting optical system PL, irradiates the photosensitive substrate P installed on the substrate stage PST. If the luminous energy of the exposure light EL is sufficiently low, then the resist of the photosensitive substrate P is not removed during development.

Then, the light source 101 is controlled with the control device CONT to gradually raise the luminous energy of the exposure light EL to irradiate the mask M2. When the gradually raised luminous energy reaches a predetermined quantity of luminous energy (a cumulative value corresponding to the amount of exposure), the part of the photosensitive substrate P irradiated with the exposure light EL, i.e., the resist in the position on the photosensitive substrate P corresponding to the transmissive portion T of the mask M2 is removed during development.

Thus, the predetermined luminous energy in this context is the cumulative luminous energy (amount of exposure) large enough for the resist to be exposed to flare in each position on the photosensitive substrate P corresponding to each position where a chromium pattern C is formed and not to be removed in the development process, and for the resist on the photosensitive substrate P corresponding to the transmissive portion T to be exposed and removed in the development process to enable a pattern to be formed.

Furthermore, whether or not a pattern is then formed on the photosensitive substrate P is detected by the shape measuring apparatus ST. The result of detection by the shape measuring apparatus ST is supplied to the control device CONT, and the control device CONT, on the basis of the result of detection by the shape measuring apparatus ST, can determine the predetermined luminous energy required for the resist in the position on the photosensitive substrate P corresponding to the transmissive portion T. Hereinafter, this predetermined luminous energy will be represented by B 1.

[Step Sb2]

Then, the light source 101 is controlled with the control device CONT to set the luminous energy of the exposure light EL to be different from the predetermined luminous energy B1 of the exposure light EL with which the mask M2 was irradiated at step Sb1. In this case the output of the light source 101 (the luminous energy of the exposure light EL emitted from the illuminating optical system IL) is set higher than the output (luminous energy) at step Sb1 to increase the luminous energy of the exposure light EL with which the mask M2 is irradiated. The exposure light EL having irradiated the mask M2 passes the transmissive portion T and the projecting optical system PL, and irradiates the photosensitive substrate P provided on the substrate stage PST.

When there is any flaring between the mask M2 including the projecting optical system PL and the photosensitive substrate P, the luminous energy on the photosensitive substrate P (image plane of the projecting optical system PL) corresponding to the positions in which the chromium patterns C of the mask M2 are formed is no longer 0. That is to say, the luminous energy in the positions in the photosensitive substrate P matching the chromium patterns C, where the luminous energy should be 0 is made non-0 by the irradiation by flare. Therefore, where there is any flare, which is shifted by raising the luminous energy of the exposure light EL, the resist is exposed to this flare in the positions on the photosensitive substrate P matching the chromium patterns C. In this case, the resist in positions on the photosensitive substrate P matching the chromium patterns C, where resist would not be removed otherwise, is removed during development. Whether or not the resist in the positions (irradiated positions) on the photosensitive substrate P matching the chromium patterns C has been removed is detected by the shape measuring apparatus ST, and the control device CONT judges, on the basis of this result of detection by the shape measuring apparatus ST, whether or not the positions on the photosensitive substrate P matching the chromium patterns C have been exposed to any flare. Hereinafter, the luminous energy of the exposure light EL at the time the resist in the positions on the photosensitive substrate P matching the chromium patterns C is removed during development will be represented by B2.

Then, the photosensitive substrate P is exposed to the luminous energy quantities greater than the luminous energy B1 at step Sb1 and differing from each other, and it is detected whether or not the resist in the positions on the photosensitive substrate P matching the chromium patterns C is removed with a certain quantity of luminous energy to determine the luminous energy B2. Furthermore, to adjust the cumulative luminous energy quantities (exposure amounts) B1 and B2 of the exposure light EL on the photosensitive substrate at steps Sb 1 and Sb2 respectively, it is sufficient to alter at least one of the intensity of the exposure light EL on the photosensitive substrate, the number of pulses of the exposure light EL irradiating the photosensitive substrate and the oscillation frequency of the light source 101. Where the exposure light EL is a continuous light, at least one of the intensity and the duration of irradiation of the photosensitive substrate with the exposure light EL can be altered. Furthermore, where the exposure apparatus in Figure 1 is of a scanning exposure type, whether the exposure light EL is a pulsed light or a continuous light, at least one of the alternatives comprising, in addition to the aforementioned intensity and other factors of the exposure light EL, the width of the area of irradiation with the exposure light EL on the photosensitive substrate regarding the scanning direction of the photosensitive substrate and the scanning speed of photosensitive substrate.

[Step Sb3]

On the basis of the result obtained at step Sb1, i.e., the luminous energy B1 of the exposure light EL (first light) having such a luminous energy as to remove the resist in the position on the photosensitive substrate P corresponding to the transmissive portion T of the mask M2 but not the resist in the positions matching the chromium patterns C, and the result obtained at step Sb2, i.e., the luminous energy B2 of the exposure light EL (second light) having such a luminous energy as causes flare to arise and removes the resist in the positions on the photosensitive substrate P matching the chromium patterns C, information on flare is acquired.
Where there is any flare between the masks M including the projecting optical system PL and the photosensitive substrate P, as shown in Figure 7, the positions on the photosensitive substrate P matching the chromium patterns C of the mask M2 is irradiated by the flare, and the resist in these parts is removed. On the other hand, where there is no flare, the luminous energy the positions on the photosensitive substrate P matching the chromium patterns C is 0, and the resist in these parts is not removed. Incidentally, in Figure 7, the horizontal axis represents the image plane position and the vertical axis, the luminous energy of the exposure light EL.
The control device CONT, if it finds on the basis of the result of measurement by the shape measuring apparatus ST that the resist on the photosensitive substrate P corresponding to the positions where the chromium patterns C are formed was removed at step Sb2, will judge that there is flaring between the mask M2 including the projecting optical system PL and the photosensitive substrate P. Then, if the luminous energy determined in step Sb1 is B1 and the luminous energy determined in step Sb2 is B2, the luminous energy B3 of flare on the photosensitive substrate P corresponding to the positions in which the chromium patterns C are formed is:

$$B3 = B1 (B1/B2) \qquad (2)$$

Incidentally, the luminous energy quantities B1 and B2 may as well be determined by direct observation with a microscope or the like instead of using the shape measuring apparatus ST.
Then, as in the first embodiment, it is detected whether or not the resist in each of the positions on the photosensitive substrate P corresponding to the positions in which the plurality of chromium patterns C are formed in the direction of the plate surface of the mask M2 has been removed and, on the basis of this detection, it is judged whether or not there is any flare in each position; if there are flare, the luminous energy of the flare in each position can be determined according to Formula (2). Thus, in this embodiment, too, it is possible to detect whether or not there is any flare and, if there is any, information on that flare including the luminous energy of the flare and the distribution of illuminance of the flare.
Thus, it is possible to detect information on the flare in each position on the photosensitive substrate P corresponding to the transmissive portion T or one or another of the chromium patterns C of the mask M2 by the pattern shape (transferred image of the chromium pattern C) formed on the photosensitive substrate P.
Incidentally, in step Sb2, it is possible to detect a flare when the predetermined luminous energy B2 is greater than the usual amount of exposure (an appropriate amount of exposure determined according to the sensitivity characteristic of the photosensitive substrate P), the predetermined luminous energy B1 at step Sb1 need not be greater than the usual amount of exposure. It has to be noted, however, that there is some flaring, though not detected, when amount of exposure is typical.
Although in step Sa2 in the first embodiment it is supposed to shift the substrate stage PST and detect with the optical detecting device DT each portion of the exposure light EL transmitted by the plurality of trimming patterns T on the mask M1, it is also possible to use, for instance, an optical detecting device having a plurality of pinholes and capable of detecting the portion of the exposure light passing each pinhole and simultaneously detect the portions of the exposure light EL transmitted by at least two trimming patterns T. Additionally, although at step Sa1 in the first embodiment only one trimming pattern T is irradiated with the exposure light EL, it is possible to detect the exposure light EL without having to shift the substrate stage PST between at least two trimming patterns T by using this optical detecting device.

Furthermore, although in the first embodiment a plurality of the trimming patterns T are formed on the mask M1, only one trimming pattern T may be formed on the mask M1, and in this case the mask stage MST is shifted, the position of the trimming pattern T is thereby varied within the irradiating area of the exposure light EL, and information on the flare in each of the plurality of positions in that irradiating area can be detected. Similarly, in the second embodiment, only one chromium pattern C on the mask M2 may be sufficient.

In addition, it is preferable for the irradiating area of the exposure light EL on the mask M1 at step Sa2 in the first embodiment and the irradiating area of the exposure light EL on the mask M2 at steps Sb1 and Sb2 in the second embodiment to be set to the same conditions (i.e. equal in size, position and shape) as at the time of transferring the patterns of the masks M.

As hitherto described, since conditions under which no flare would be detected are set in advance, information on the exposure light EL on the image plane of the projecting optical system PL under these conditions is detected, and then information on the exposure light EL on the image plane of the projecting optical system PL is detected under predetermined conditions, it is made possible to quantitatively detect flare arising on the optical system IL and PL. Therefore, predetermined processing to eliminate flare and processing, for instance, to adjust the angles of the optical members constituting the optical system to the optical axis AX among others can be accomplished efficiently. Furthermore, the measurement of flare can be carried out by using the masks M1 and M2 having a predetermined pattern, making it possible to realize stable measurement with a simple configuration.

As flare is measured in a disposition in which the illuminating optical system IL and the projecting optical system PL are separated from each other, it is possible to easily and accurately identify, for instance, the location on the optical path where there is any flare, whether it is in the illuminating optical system IL or in the projecting optical system PL. Therefore, it is possible to efficiently perform processing to eliminate flare in advance of exposure to light or before shipping the exposure apparatus. For instance, at least one optical member of the illuminating optical system IL or the projecting optical system PL is adjusted in position or replaced. More specifically, in the illuminating optical system IL the relay lens line may be replaced, and in the projecting optical system PL the optical member closest to the photosensitive substrate (such as a lens element, an aberration correcting plate or a plane-parallel plate) is replaced.

Incidentally, the trimming patterns T of the mask (first mask) M1 shown in Figure 2 and the chromium patterns C of the mask (second mask) M2 shown in Figure 5 are formed in substantially the same positions in the respective masks in the direction of the plate surface, and the trimming patterns T and the chromium patterns C are reversed in the two masks. This configuration makes it possible to measure flare in the same positions, in the direction perpendicular to the optical axis AX, on the illuminating optical system IL and the projecting optical system PL. Thus, much information regarding flare can be acquired, including identification of the position of the exposable face where the flaring is the greatest.

In addition, as the exposure apparatus EX in this embodiment, a scanning type exposure apparatus for exposing the masks M to patterns by synchronously shifting the masks M and the photosensitive substrate P can also be applied.

Since the irradiating area of the exposure light EL is defined in a slit shape in a scanning type exposure apparatus, only parts of the masks M1 and M2, i.e., the central oblong parts indicated by dotted lines in Figure 2 and Figure 5 are irradiated with the exposure light EL at step Sa2 in the first embodiment and at step Sb2 in the second embodiment. In addition, the other areas than the central oblong parts, also indicated by dotted lines in Figure 2 and Figure 5 represent the irradiating areas of the exposure light EL in a stationary type exposure apparatus in which, for instance, the patterns of the masks are transferred to the photosensitive substrate with the masks M and the photosensitive substrate P kept substantially stationary. Thus, the masks shown in Figure 2 and Figure 5 can be used in both scanning type and stationary type exposure apparatuses. Furthermore, when the photosensitive substrate P is to be exposed to the exposure light EL via the mask M2 at step Sb2 in the second embodiment, one of a scanning exposure system in which the masks M and the photosensitive substrate P is shifted relative to the exposure light EL and a stationary exposure system in which the masks M and the photosensitive substrate P are kept substantially stationary can be used.

In the second embodiment described above, whereas measurement of flare arising between the mask M1 including the projecting optical system PL and the photosensitive substrate P is carried out, without using the optical detecting device DT, by transferring the pattern image of the mask M2 to the photosensitive substrate P and the measurement is based on the result of detection of the pattern shape that has been formed, this is because the reflection of the exposure light EL by the photosensitive substrate P towards the projecting optical system PL is great. Therefore, since it is possible to detect the light component reflected by the photosensitive substrate P can also be detected by measuring flare in a state in which the photosensitive substrate P is actually installed on the substrate stage PST, accurate measurement is made possible.

On the other hand, if in the second embodiment only such flare as are attributable to the projecting optical system PL are to be measured, a reflection-preventive device (anti-reflection film or the like) can be provided on the substrate stage PST, the mask M2 irradiated with the exposure light EL in this state, and information on the exposure light EL detected with the optical detecting device DT on the image plane of the projecting optical system PL.

In addition, in the first embodiment, when flare arising on the illuminating optical system IL are to be measured, the exposure light EL having passed the projecting optical system PL is detected with the optical detecting device DT on the substrate stage PST and the measurement is based on the result of detection of this detection, but the flare arising on the projecting optical system PL are negligibly small in quantity, even the aforementioned configuration can accurately measure flare arising on the illuminating optical system IL. Thus, whereas flare is mainly generated from the exposure light EL reflected by the photosensitive substrate P, since the photosensitive substrate P is not installed on the substrate stage PST in the first embodiment shown in Figure 3, flare arising on the illuminating optical system IL can be measured at a predetermined level of accuracy.

In the configuration of the second embodiment, flare arising between the masks M including the projecting optical system PL and the photosensitive substrate P are measured on the basis of the values of two luminous energy quantities including the luminous energy B I with which only the resist on the photosensitive substrate P corresponding to the position in which the transmissive portion T of the mask M2 is formed is removed and the luminous energy B2 with which the resist on the photosensitive substrate P corresponding to the positions in which the chromium patterns C are formed also is removed.

It is also possible to use here a configuration in which a plurality of sets of data regarding the lost quantity of resist when the luminous energy of the exposure light EL working on the photosensitive substrate P is varied in a random manner are determined in advance by experiment, the plurality of data (data table) are stored in advance into the control device CONT, then the mask M2 is irradiated with the exposure light EL whose luminous energy is varied in a random way, the lost quantity of resist in the positions on the photosensitive substrate P matching the chromium patterns C is detected with the shape measuring apparatus ST, this detected lost quantity of resist is compared with the data table, and the control device CONT is thereby caused to determine the luminous energy of lights(flaring) irradiating the resist in the positions on the photosensitive substrate P matching the chromium patterns C.

Where the measurement of flare arising between the masks M including the projecting optical system PL and the photosensitive substrate P in the second embodiment is done by a configuration using the photosensitive substrate P, since it is sufficient to detect the influence of the resist in this measurement, the illuminance of the exposure light EL on the image plane of the projecting optical system PL may be detected by, for instance, providing an object (a thin film or the like) having an equal reflectance to the resist all over the projection area of the projecting optical system PL, and the optical detecting device DT arranged in predetermined positions on the substrate stage PST corresponding to the positions in which the chromium patterns C are formed. In this case, the provision of the object having an equal reflectance to the resist enables flare to be measured under substantially the same conditions as those in which the photosensitive substrate P is provided, thereby making possible accurate measurement.

Furthermore, although the present invention in the above-described modes of implementation is supposed to be applied to the adjustment of exposure apparatuses, the invention can as well be applied to the manufacturing process of exposure apparatuses. Also, while the exposure apparatus in those modes of implementation is supplied to have a function to measure flare, the exposure apparatus need not have that measuring function. For instance, at the time of assembly and adjustment at the manufacturing plant of exposure apparatuses, that measuring function can be used to measure flare on the illuminating optical system and the projecting optical system incorporated into the exposure apparatus per se, optical members of the illuminating optical system or the projecting optical system adjusted or replaced on the basis of the result of measurement, and the measuring function removed when shipping the exposure apparatus.

In addition, in an exposure apparatus having an ArF excimer laser as its light source 101, disrupting substances (including ions and organic substances) are present on the optical path including the illuminating optical system and the projecting optical system, and these disrupting substances not only vary (reduce) the transmissivity (or the reflectance) of the illuminating optical system and the projecting optical system but also may give rise to much flaring. For this reason, the invention is particularly effective for exposure apparatuses in which disrupting substances may give rise to changes in the transmissivity of the illuminating optical system or the projecting optical system.

In the modes of implementation described above, the exposure apparatus EX is not limited in use to exposure in the manufacture of semiconductors, but can be extensively applied, for instance, as an exposure apparatus for liquid crystals in exposing rectangular glass plates to a liquid crystal display element pattern and ones for exposure use in the manufacture of thin-film magnetic heads, image pickup elements, micro-machines and masks (reticles).

The projecting optical system PL may be any of the reducing, equi-multiplying and enlarging lines or any of the refractive, reflecto-refractive and reflective lines. Also, the light source 101 is not limited to an excimer laser, but may as well be harmonic generating device such as a mercury lamp, a YAG laser or a semiconductor laser. Furthermore, the exposure light EL is not limited to ultraviolet rays, but may also be an EUV, hard X-rays, or a charged particle ray such as an electron beam or an ion beam.

As hitherto described, an exposure apparatus in the modes of implementation covered by the present application is manufactured by assembling various subsystems containing constituent elements cited in the claims of this patent application so as to preserve predetermined mechanical precision, electrical precision and optical precision. In order to ensure precision in these aspects, before and after assembly, the optical systems are adjusted to achieve the optical precision, the mechanical systems are adjusted to achieve the mechanical precision, and the electrical systems are adjusted to achieve the electrical precision. The process of assembling various subsystems into the exposure apparatus includes mechanical connection of the subsystems, wiring connection of electrical circuits and piping connection of pneumatic circuits. Needless to say this process of assembling various subsystems into the exposure apparatus is preceded by the assembling processes of individual subsystems. Upon completion of the assembly of various subsystems into the exposure apparatus, overall adjustment is made to ensure precision in various aspects of the whole exposure apparatus. At this stage, flare may be measured as described with reference to the modes of implementation, and optical members of the illuminating optical system and the projecting optical system may be adjusted or replaced as required. In addition, it is desirable for the exposure apparatus to be manufactured in a clean room in which the temperature and cleanness are controlled.

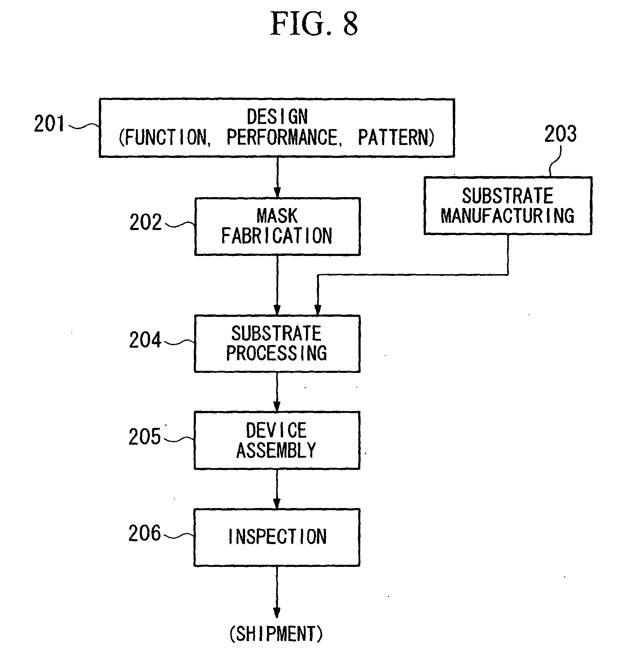

A semiconductor device is manufactured, as shown in Figure 8, through steps including step 201 of designing the functions and performance features of the device, step 202 of fabricating masks (reticles) based on this design step, step 203 of manufacturing a substrate (wafer or glass plate) to constitute the base of the device, wafer processing step 204 of exposing the wafer to the reticle pattern with exposure apparatus in the above-described embodiment, device assembling step (including a dicing step, a bonding step and a packaging step) 205 and inspection step 206.

Industrial Applicability

The flare measuring method and the flare measuring apparatus, the exposure method and the exposure apparatus, and the exposure apparatus adjusting method according to the present invention have the following advantages.

In a flare measuring method according to one aspect of the invention and a flare measuring apparatus according to one aspect of the invention, it is possible to irradiate an optical path including masks having predetermined patterns with a first and second lights, detect information on each light in a predetermined position on the optical path, and acquire information on flare occurring on the optical system on the basis of the respective detection results. Therefore, on the basis of the information on flare acquired quantitatively, predetermined processing to eliminate the flare can be accomplished efficiently.

Since, according to a flare measuring method according to the one aspect of the invention, conditions under which no flare occurs on the optical system are set in advance and the first light is radiated under these conditions, it is possible to accurately measure flare occurring on the optical system on the basis of the result of this detection regarding the first light.

Since, according to a flare measuring method according to another aspect of the invention, conditions under which no flare is detected are set in advance and the first light is radiated under these conditions, it is possible to accurately measure flare occurring on the optical system on the basis of the result of this detection regarding the first light.

In a flare measuring method according to the other aspect of the invention and a flare measuring apparatus according to the other aspect of the invention, by installing a substrate having a transmissive pattern capable of transmitting light downstream on the optical path of the illuminating optical system, irradiating only this transmissive pattern with the light to detect information on the illuminance of this light in a predetermined position on the optical path, and then detecting information on illuminance in a predetermined position on the optical path corresponding to the position of the transmissive pattern when the whole substrate is irradiated with the light with its range of irradiation varied, it is possible to quantitatively detect flare on the optical path upstream of the substrate on the basis of the difference between these results of detection.

In a flare measuring method according to the other aspect of the invention and a flare measuring apparatus according to the other aspect of the invention, by installing a substrate having a light intercepting pattern capable of intercepting light upstream on the optical path of the optical system, irradiating the whole of this substrate with light to detect information on luminous energy in a predetermined position on the optical path corresponding to the position of the light intercepting pattern, then varying the luminous energy to detect information on luminous energy in a predetermined position on the optical path corresponding to the position of the light intercepting pattern when the whole substrate is irradiated with the light, it is possible to quantitatively detect flaring on the optical path downstream of the substrate on the basis of the difference between these results of detection.

In a flare measuring method according to another aspect of the invention, by providing a plurality of patterns in a direction perpendicular to the optical axis of light, it is possible to measure flare occurring in a plurality of positions in the direction perpendicular to the optical axis of light.

In a flare measuring apparatus according to yet another aspect of the invention, as it is provided with an irradiating range adjusting device for adjusting the irradiating range of light irradiating the optical path, it is possible to realize irradiation of only a specific pattern with the light stably. Therefore, flare measurement can be accomplished accurately and stably.

In a flare measuring method according to the other aspect of the invention and a flare measuring apparatus according to the other aspect of the invention, it is possible to accomplish accurate transfer processing (exposure processing) because flare occurring on the optical system are measured, and transfer processing can be carried out after performing predetermined processing to eliminate flare on the basis of the result of this detection.

By an exposure apparatus adjusting method according to one aspect of the invention, it is possible to easily adjust and efficiently the exposure apparatus to make uniform the distribution of illuminance because the distribution of illuminance on the masks can be determined in a state in which the influence of flare that have arisen is taken into account.

By an exposure apparatus adjusting method according to another aspect of the invention, it is possible to adjust easily and efficiently the exposure apparatus to make uniform the distribution of illuminance because the distribution of illuminance on the image plane of the projecting optical system can be determined in a state in which the influence of flare that have arisen is taken into account.

By an exposure apparatus adjusting method according to the other aspect of the invention, it is possible to measure flare in the same positions on the illuminating optical system and the projecting optical system in the direction perpendicular to the optical axis. Therefore, much information regarding flare can be acquired, including the position on the exposable face where the flaring is greater.

By an exposure apparatus adjusting method according to the other aspect of the invention, it is possible to accomplish accurate detection while dispensing with the optical detecting device because information on the luminous energy of the illuminating light is acquired by detecting the transferred image of the light intercepting pattern.

By an exposure apparatus adjusting method according to the other aspect of the invention, it is possible to securely acquire information regarding flare which occur under the same conditions as the transfer processing because the irradiating area is set to the same conditions as at the time of transferring the mask patterns to the substrates. Therefore, it is possible to easily and efficiently adjust the exposure apparatus to make uniform the distribution of illuminance.

## Claims

1. A flare measuring method for measuring flare occurring on optical system, comprising the steps of:

   irradiating an optical path including a substrate having a predetermined pattern and said optical system with first light and detecting information on the light in a predetermined position on said optical path;
   irradiating said optical path with second light differing from said first light in at least one of luminous energy and irradiating range and detecting information on the light in a predetermined position on said optical path, and
   acquiring information on said flare on the basis of respective detection results regarding said first and second light.

2. The flare measuring method according to claim 1, wherein

   the range of irradiating said optical path with said first light is set in advance to condition under which no flare occurs on the optical system.

3. The flare measuring method according to claim 1, wherein

   a substrate provided with a transmissive pattern capable of transmitting light and having a predetermined size is installed downstream on the optical path of the optical system to be irradiated with said light, said transmissive pattern is irradiated with the first light to detect information on the luminous energy of the first light on the optical path, said substrate is irradiated with the second light whose range of irradiation is varied from said first light to detect information on the luminous energy of the second light in a predetermined position on said optical path corresponding to the position of said transmissive pattern.

4. The flare measuring method according to claim 1, wherein

   the luminance of said first light when irradiating said optical path is set in advance to condition under which no flare is detected.

5. The flare measuring method according to claim 1, wherein

   a substrate provided with a light intercepting pattern capable of intercepting light and having a predetermined size is installed upstream on the optical path of the optical system to be irradiated with said light, said substrate is irradiated with the first light to detect information on the luminous energy of the first light in a predetermined position on the optical path corresponding to the position of said light intercepting pattern, then said substrate is irradiated with the second light whose luminous energy is varied from said first light to detect information on the luminous energy of the second light in a predetermined position on said optical path corresponding to the position of said light intercepting pattern.

6. The flare measuring method according to claim 1, wherein

a plurality of said patterns are provided in a direction perpendicular to the optical axis of said light, and information on the luminous energy of the light is detected in a predetermined position on said optical path corresponding to each pattern.

7. A flare measuring apparatus for measuring flare occurring on optical systems, comprising:

a light source device irradiating an optical path including said optical system with light;
a substrate arranged on said optical path and having a predetermined pattern;
a detecting device arranged in a predetermined position on said optical path and capable of detecting information regarding the luminous energy of said light, and
a control device capable of controlling at least one of the luminous energy and the irradiating range of the light emitted from said light source device and acquiring information on said flare on the basis of a result of detection by said detecting device of the light irradiated on said optical path.

8. The flare measuring apparatus according to claim 7, wherein

said substrate is provided with a transmissive pattern capable of transmitting light and has a predetermined size, and
said control device determines information on the luminous energy of the light on the basis of information on the luminous energy of the light detected by irradiating said transmissive pattern with the light and information on the luminous energy of the light detected by said detecting device in a predetermined position on said optical path corresponding to the position of said transmissive pattern by irradiating said substrates with the light.

9. The flare measuring apparatus according to claim 7, wherein:

said substrate is provided with a light intercepting pattern capable of intercepting light and having a predetermined size, and
said control device determines information on the luminous energy of the flare on the basis of information on the luminous energy of the light by said detecting device in a predetermined position on said optical path corresponding to the position of said light intercepting pattern by irradiating said substrate with the light and information on the luminous energy of the light detected by said detecting device in a predetermined position on said optical path corresponding to the position of said light intercepting pattern by irradiating said substrate with light varied in luminous energy from said light.

10. The flare measuring apparatus according to claim 7, further comprising: an irradiating range adjusting device which adjusts the irradiating range of the light irradiating said optical path.

11. An exposure method in which a mask having a pattern is irradiated with an exposure light from an illuminating optical system and an image of the pattern is transferred onto a photosensitive substrate via a projecting optical system, said exposure method comprising the steps of:

measuring flare occurring on each of the optical systems by a flare measuring method according to claim 1 and, after predetermined process is performed on the basis of the measurement results, carrying out said transfer process.

12. An exposure apparatus including an illuminating optical system and a projecting optical system, comprising: a flare measuring apparatus according to claim 7.

13. A method for adjusting an exposure apparatus including an illuminating optical system for irradiating a mask with illuminating light from a light source and by which a pattern of the mask is transferred onto a substrate, said method comprising the steps of:

irradiating substantially only a transmissive pattern with said illuminating light in an area of irradiation by said illuminating optical system to detect a transmitted light;
irradiating substantially the whole of said irradiated area with said illuminating light to detect the light transmitted by said transmissive pattern, and

determining on the basis of the detection result the distribution of illuminance of said illuminating light on said mask.

14. The exposure apparatus adjusting method according to claim 13, wherein

said exposure apparatus has a projecting optical system for projecting said illuminating light on said substrate, and a light intercepting pattern is arranged in said irradiating area, and said illuminating light is radiated with its luminous energy varied to detect information on the luminous energy of said illuminating light in the position of projection of said light intercepting pattern by said projecting optical system, and the distribution of illuminance of said illuminating light on an image plane of said projecting optical system is determined on the basis of the result of detection.

15. An exposure apparatus adjusting method according to claim 14, wherein

said light intercepting pattern is arranged in substantially the same position as said transmissive pattern in said irradiating area.

16. An exposure apparatus adjusting method according to claim 15, wherein

a transmissive portion and a light intercepting portion are reversed between a first mask on which said transmissive pattern is formed and a second mask on which said light intercepting pattern is formed.

17. A method for adjusting an exposure apparatus including an illuminating optical system for irradiating a mask with illuminating light from a light source and a projecting optical system for projecting said illuminating light on a substrate, said method comprising the steps of:

arranging a light intercepting pattern in an area of irradiation by said illuminating optical system with said illuminating light; irradiating said illuminating light with its luminous energy varied to detect information on the luminous energy of said illuminating light in the position of said light intercepting pattern projected by said projecting optical system, and determining an illuminance distribution of said illuminating light on an image plane of said projecting optical system on the basis of the result of the detection.

18. An exposure apparatus adjusting method according to claim 14, wherein

information on the luminous energy of said illuminating light is acquired by detecting a transferred image of said light intercepting pattern which is obtained by irradiating a photosensitive substrate with said illuminating light.

19. An exposure apparatus adjusting method according to claim 13, wherein

said irradiating area is set to the same condition as at the time of transferring said mask pattern onto said substrate.

EP 1 308 991 A1

FIG. 1

# FIG. 2

FIG. 3

# FIG. 4

LUMINANCE
(LUMINOUS ENERGY)

A2 { A3 / A1
(a)
PERIPHERAL
PART

A2 { A3 / A1
(b)
CENTER

A2 { A3 / A1
(c)
PERIPHERAL
PART

POSITION OF
IMAGE PLANE

# FIG. 5

M2

C

T

# FIG. 6

# FIG. 7

# FIG. 8

201 — DESIGN
(FUNCTION, PERFORMANCE, PATTERN)

203

202 — MASK
FABRICATION

SUBSTRATE
MANUFACTURING

204 — SUBSTRATE
PROCESSING

205 — DEVICE
ASSEMBLY

206 — INSPECTION

(SHIPMENT)

## INTERNATIONAL SEARCH REPORT

| | International application No. |
|---|---|
| | PCT/JP01/06429 |

A. CLASSIFICATION OF SUBJECT MATTER
    Int.Cl⁷   H01L21/027, G03F7/20, G01J1/00, G01B11/00

According to International Patent Classification (IPC) or to both national classification and IPC

B. FIELDS SEARCHED

Minimum documentation searched (classification system followed by classification symbols)
    Int.Cl⁷   H01L21/027, G03F7/20, G01J1/00, G01B11/00

Documentation searched other than minimum documentation to the extent that such documents are included in the fields searched
    Jitsuyo Shinan Koho        1926-1996    Toroku Jitsuyo Shinan Koho  1994-2001
    Kokai Jitsuyo Shinan Koho  1971-2001    Jitsuyo Shinan Toroku Koho  1996-2001

Electronic data base consulted during the international search (name of data base and, where practicable, search terms used)
    INSPEC

C. DOCUMENTS CONSIDERED TO BE RELEVANT

| Category* | Citation of document, with indication, where appropriate, of the relevant passages | Relevant to claim No. |
|---|---|---|
| A | Proceedings of the SPIE, Vol.3051, pages 708 to 713, (1997), (USA), "Measuring Flare and Its effect on Process Latitude" | 1-19 |
| A | JP 8-179513 A (Canon Inc.), 12 July, 1996 (12.07.96), page 1     (Family: none) | 1-19 |
| A | JP 5-241077 A (Olympus Optical Co., Ltd.), 21 September, 1993 (21.09.93), page 1     (Family: none) | 1-19 |

☐ Further documents are listed in the continuation of Box C.      ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 22 October, 2001 (22.10.01) | 30 October, 2001 (30.10.01) |

| Name and mailing address of the ISA/ | Authorized officer |
|---|---|
| Japanese Patent Office | |
| Facsimile No. | Telephone No. |

Form PCT/ISA/210 (second sheet) (July 1992)

22